# EUROPÄISCHE PATENTSCHRIFT

(11) **EP 2 850 837 B1**
(45) Veröffentlichungstag und Bekanntmachung des Hinweises auf die Patenterteilung: **20.05.2020**
(21) Anmeldenummer: 13713142.1
(22) Anmeldetag: 25.03.2013
(51) Int. Cl.: H04N 9/31, H01S 5/40, G06F 3/03

(54) **LASERMODUL MIT DUOCHROMATISCHER LASERDIODE FÜR EINEN TRAGBAREN BILDPROJEKTOR UND VERFAHREN ZUM ERZEUGEN VON BILDERN MIT EINEM TRAGBAREN BILDPROJEKTOR**
LASER MODULE WITH DUOCHROMATIC LASER DIODE FOR A PORTABLE IMAGE PROJECTOR AND METHOD FOR GENERATING IMAGES WITH A PORTABLE IMAGE PROJECTOR
MODULE LASER COMPRENANT UNE DIODE LASER DICHROMATIQUE POUR UN PROJECTEUR D'IMAGES PORTATIF ET MÉTHODE DE GÉNÉRATION D'IMAGES AVEC UN PROJECTEUR D'IMAGES PORTATIF

(30) Priorität: 15.05.2012 DE 102012208113
(43) Veröffentlichungstag der Anmeldung: 25.03.2015
(73) Patentinhaber: Robert Bosch GmbH, 70442 Stuttgart (DE)
(72) Erfinder: FISCHER, Frank, 72810 Gomaringen (DE); PILARD, Gael, 72127 Wankheim (DE)
(86) Internationale Anmeldenummer: PCT/EP2013/056299
(87) Internationale Veröffentlichungsnummer: WO 2013/170988

(56) Entgegenhaltungen:
- EP-A1- 2 120 455
- EP-A2- 1 411 733
- WO-A1-2009/031094
- US-A1- 2009 128 717

## Beschreibung

Die Erfindung betrifft ein Lasermodul mit duochromatischer Laserdiode für einen tragbaren Bildprojektor, einen tragbaren Bildprojektor mit einem derartigen Lasermodul und ein Verfahren zum Erzeugen von Bildern mit einem tragbaren Bildprojektor, insbesondere bei miniaturisierten Bildprojektoren mit Interaktivitätsfunktionalität.

### Stand der Technik

Mikrospiegelsysteme spielen eine zunehmende Rolle in Bildprojektoren für tragbare Anwendungen wie beispielsweise Smartphones, Kameras, PDAs oder Tablet-PCs. Häufig basieren derartige Bildprojektoren auf Rasterscanverfahren, bei denen ein Laserstrahl durch verstellbare Mikrospiegel über eine vordefinierte Rastermatrix gescannt wird.

Interaktive Anwendungen benötigen zusätzlich zu den bildgebenden Laserstrahlen einen weiteren Laserstrahl, welcher an Eingabegeräten oder Körperteilen eines Nutzers in der Umgebung des Bildprojektors gestreut oder reflektiert wird, und dessen reflektierter Anteil die Erfassung von Bewegungen in der Umgebung des Bildprojektors ermöglicht. Die Druckschriften US 2010/0201895 A1, US 2011/0181553 A1 und US 7,525,538 B2 offenbaren jeweils Bildprojektionssysteme mit Interaktivitätsfunktionalität.

Die WO 2009/031094 A1 beschreibt eine Projektionsvorrichtung mit zumindest einer Laserstrahlquelle und einer scannenden Einrichtung zum Scannen eines externen Projektionsbereichs innerhalb eines Projektionskonus mit der Laserstrahlquelle, wobei die Vorrichtung eine Erfassungseinrichtung zum Detektieren der Gegenwart eines Auges von einem Lebewesen im Projektionskonus und eine Steuereinrichtung umfasst, um die Projektionsintensität des Laserstrahls zu reduzieren, falls ein Auge eines Lebewesens erfasst wird, wobei ein begrenzter Bereich um die Augenposition in der Projektionsintensität reduziert wird und der außerhalb des begrenzten Bereichs im Projektionskonus eine anfängliche Projektionsintensität beibehalten wird. Die Vorrichtung umfasst drei einzelne Laserstrahlquellen jeweils für die Farben rot, grün und blau. Zur Detektion umfasst die Vorrichtung eine Infrarotstrahlenquelle, einen Infrarotsensor und einen geeigneten Strahlensplitter, um die reflektierten IR-Strahlen zu empfangen.

Die US 2009/128717 A1 beschreibt eine Bildprojektionsvorrichtung zum Anzeigen von Bildern auf einer Projektionsfläche durch Anwendung von Laserstrahlen mit den drei Farben grün, blau, rot auf eine Projektionsfläche. Dabei umfasst die Vorrichtung eine Laservorrichtung mit einem Laserstrahl mit einer Wellenlänge und eine zweite Laservorrichtung mit zwei emittierenden Laserstrahlen mit zwei Laserwellen, die zwei der drei Farben aufweisen. Die Vorrichtung umfasst ein synthetisierendes Element, das einen optischen Weg der drei Laserstrahlen zusammenlegt und eine Scanvorrichtung, die die zusammengelegten Laserstrahlen Pixel für Pixel auf die Projektionsfläche überträgt, um ein Bild zu erzeugen.

Es besteht ein Bedarf an Lasermodulen für Bildprojektoren und Verfahren zum Erzeugen von Bildern mit einem Bildprojektor, die kostengünstig, effizient und platzsparend zu implementieren sind, und die eine Interaktivitätsfunktionalität des Bildprojektors ermöglichen.

### Offenbarung der Erfindung

Die Erfindung wird durch den unabhängigen Ansprüchen definiert. Die abhängigen Ansprüche definieren vorteilhafte Ausführungsformen.

### Vorteile der Erfindung

Es ist eine Idee der vorliegenden Erfindung, in einem Lasermodul mit mehreren monochromatischen Laserdioden eine der Laserdioden durch eine duochromatische Laserdiode zu ersetzen. Die duochromatische Laserdiode stellt dabei neben einem Laserstrahl mit einer Hauptwellenlänge einen weiteren Laserstrahl mit einer Nebenwellenlänge bereit, die beide mit der gleichen Kollimatoroptik zu einem gemeinsamen Strahl gebündelt werden. Dieser Strahl wird dann über optische Elemente mit den Laserstrahlen der übrigen Laserdioden gebündelt, so dass eine multispektrale Laserlichtquelle geschaffen wird, die neben den bildgebenden Laserstrahlen verschiedener Wellenlängen einen zusätzlichen Laserstrahl für die Implementierung einer Interaktivitätsfunktionalität bereitstellt.

Ein erheblicher Vorteil dieses Lasermoduls besteht darin, dass das Lasermodul mehr Laserstrahlen verschiedener Wellenlängen bereitstellt als Laserdioden nötig sind. Dadurch kann der Komponenten- und Bauraumbedarf des Lasermoduls gesenkt werden, was wiederum die Fertigungskosten senken kann und der Miniaturisierung eines das Lasermodul beinhaltenden Bildprojektionssystems förderlich ist.

Zudem können optische Elemente wie eine zusätzliche Kollimatoroptik eingespart werden, da der zusätzliche Laserstrahl über die gleichen optischen Komponenten wie der Laserstrahl mit der Hauptwellenlänge aus der duochromatischen Laserdiode verarbeitet werden kann. Ebenfalls kann auf zusätzliche optische Elemente wie dichroitische Spiegel verzichtet werden, was die Lichtausbeute des Lasermoduls und damit dessen Effizienz optimiert.

Ein weiterer Vorteil besteht darin, dass das Lasermodul nur auf die bildgebenden Laserstrahlen justiert werden muss, da der zusätzliche Laserstrahl durch die einheitliche Kollimatoroptik in einem gewissen Genauigkeitsrahmen mitjustiert wird. Dies erleichtert die Einstellung und optische Anpassung des Lasermoduls erheblich.

Weiterhin besteht ein Vorteil darin, dass der zusätzliche Laserstrahl zeitgleich mit dem bildgebenden Laserstrahl über eine Projektionsfläche gescannt werden kann, so dass zusätzliche Informationen über die exakte Position des zusätzlichen Laserstrahls in dem Bildprojektionssystem inhärent verfügbar ist. Diese Informationen können zur Verbesserung der Genauigkeit und der Präzision einer Interaktivitätsfunktionalität genutzt werden. Die Wellenlängen der bildgebenden Laserstrahlen können gegenüber der Wellenlänge des zusätzlichen Laserstrahls bei der Erfassung von interaktiven Gesten oder Bewegungen gefiltert werden, was das Signal-zu-Rausch-Verhältnis und damit die Erfassungsgenauigkeit optimieren kann.

Gemäß einer Ausführungsform des erfindungsgemäßen Lasermoduls kann das Lasermodul weiterhin eine zweite monochromatischen Laserdiode, welche dazu ausgelegt ist, ein drittes Strahlenbündel mit Laserlicht einer vierten Wellenlänge zu erzeugen, eine dritte Kollimatoroptik, welche dazu ausgelegt ist, das dritte Strahlenbündel zu kollimieren, und eine zweite optische Zusammenführeinrichtung aufweisen, welche dazu ausgelegt ist, das erste, zweite und dritte Strahlenbündel zu einem Ausgangsstrahlenbündel des Lasermoduls zusammenzuführen. Dieses Lasermodul kann in vorteilhafter Weise als RGB-Modul ausgestaltet sein, welches zusätzlich zu den bildgebenden Laserstrahlen einen zusätzlichen Laserstrahl für Interaktionsanwendungen bereitstellt.

Gemäß einer weiteren Ausführungsform des erfindungsgemäßen Lasermoduls kann die erste, zweite und dritte Kollimatoroptik jeweils zwei Linsen umfassen.

Gemäß einer weiteren Ausführungsform des erfindungsgemäßen Lasermoduls können die erste, dritte und vierte Wellenlänge im sichtbaren optischen Bereich liegen, und die zweite Wellenlänge im Infrarotbereich liegen. Infrarotlicht eignet sich besonders gut für die Implementierung einer Interaktivitätsfunktionalität.

Gemäß einer weiteren Ausführungsform des erfindungsgemäßen Lasermoduls kann die duochromatische Laserdiode in einem TO-Package gehäust sein. Derartige duochromatische Laserdioden sind vorteilhafterweise miniaturisierte Bauformen, die sich in platzsparenden Lasermodulen gut einbauen lassen.

Gemäß einer weiteren Ausführungsform des erfindungsgemäßen Lasermoduls können die erste und zweite optische Zusammenführeinrichtung dichroitische Spiegel umfassen.

Gemäß einer weiteren Ausführungsform des erfindungsgemäßen Lasermoduls kann die erste Kollimatoroptik auf ein Kollimieren des Laserlichts der ersten Wellenlänge eingestellt ist. Dadurch ist eine hervorragende Bildqualität für die von einem das Lasermodul einsetzenden Bildprojektionssystem gewährleistet, während eine geringfügige Abweichung von einer optimalen Kollimation für den zusätzlichen Laserstrahl aufgrund der geringeren benötigten Auflösung von Objektpositionen und Objektbewegungen in Kauf genommen werden kann.

Gemäß einer Ausführungsform des erfindungsgemäßen Verfahrens kann das Verfahren weiterhin die Schritte des Erfassens von an in der Nähe der Projektionsfläche befindlichen Objekten reflektierten Strahlen des Laserstrahls der zweiten Wellenlänge, und des Ermittelns von Objektpositionen oder Objektbewegungen der Objekte auf der Basis der erfassten reflektierten Strahlen. Dadurch kann eine Interaktivitätsfunktionalität implementiert werden.

Gemäß einer weiteren Ausführungsform des erfindungsgemäßen Verfahrens kann das Verfahren weiterhin die Schritte des Erzeugen eines dritten Strahlenbündels mit einem Laserstrahl einer vierten Wellenlänge mithilfe einer monochromatischen Laserdiode, des Kollimierens des dritten Strahlenbündels mithilfe einer dritten Kollimatoroptik, wobei die dritte Kollimatoroptik auf den Laserstrahl der vierten Wellenlänge eingestellt ist, und des Zusammenführens des ersten, zweiten und dritten Strahlenbündels zu einem Ausgangsstrahlenbündel umfassen.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Die beschriebenen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt. Richtungsangaben wie "links", "rechts", "oben", "unten", "über", "unter", "neben" oder dergleichen sind in der folgenden Beschreibung lediglich zu erläuternden Zwecken verwendet und stellen keine Beschränkung der Allgemeinheit dar.

Es zeigen:
- Fig. 1: eine schematische Darstellung eines Bildprojektionssystems gemäß einer Ausführungsform der vorliegenden Erfindung; und
- Fig. 2: eine schematische Darstellung eines Verfahrens zum Erzeugen von Bildern mit einem Bildprojektionssystem gemäß einer weiteren Ausführungsform der vorliegenden Erfindung.

Bildprojektionssysteme im Sinne der vorliegenden Erfindung umfassen alle miniaturisierten Projektionssysteme, die auf einer rasterscanartigen Projektion von ortsgebündelten Lichtstrahlen beruhen. Beispielsweise können Bildprojektionssysteme digitale Mikrospiegelsysteme (DMD, "digital micromirror devices"), digitale Lichtverarbeitungssysteme (DLP, "digital light processing"), Flächenlichtmodulatoren (SLM, "spatial light modulators") oder ähnliche Systeme umfassen. Derartige Bildprojektionssysteme können beispielsweise in tragbaren bzw. mobilen Geräten eingesetzt werden, wie zum Beispiel Smartphones, Mobiltelefonen, Digitalkameras, PDAs, Tablet-PCs, Notebooks, Laptops, Navigationsgeräten, Unterhaltungselektronikgeräten oder ähnlichen Einrichtungen.

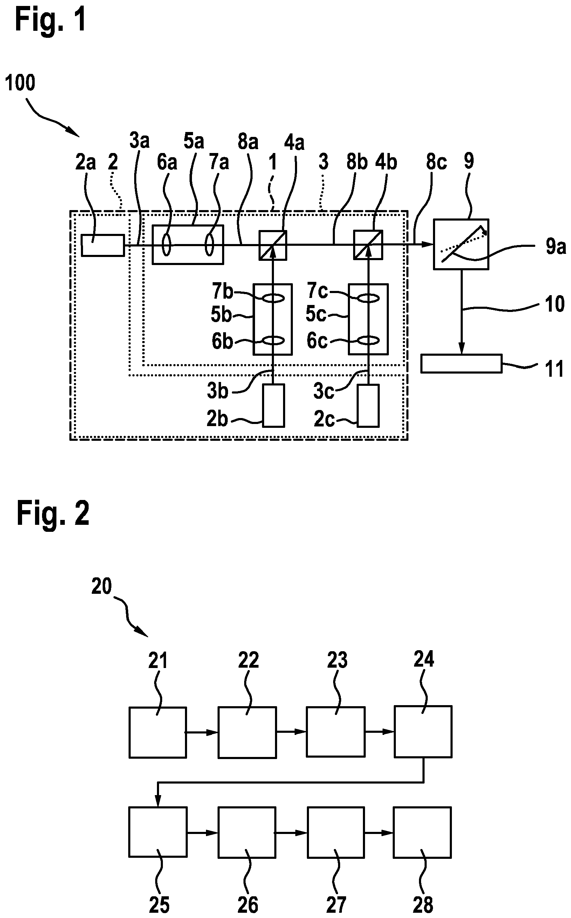

Fig. 1 zeigt eine schematische Darstellung eines Bildprojektionssystems 100. Das Bildprojektionssystem 100 umfasst ein Lasermodul 1, welches gebündeltes Laserlicht 8c an ein Mikrospiegelsystem 9 mit Mikrospiegeln 9a abgibt. Das Mikrospiegelsystem 9 kann derart angesteuert werden, dass das gebündelte Laserlicht 8c als Scanstrahl 10 über eine Projektionsfläche 11, beispielsweise einem Bildschirm, einer Leinwand, einem Display oder einer sonstigen Bildanzeigeeinrichtung, matrixartig über ein Rasterscanverfahren gescannt wird. Über diese hochfrequente Ansteuerung kann mit dem Scanstrahl 10 ein Bild bzw. eine Bildsequenz erzeugt werden, die für einen Betrachter der Projektionsfläche 11 optisch wahrnehmbar ist.

Das Lasermodul 1 umfasst eine Laserdiodenanordnung 2 und eine Optikanordnung 3. Die Laserdiodenanordnung 2 umfasst im vorliegenden Beispiel drei Laserdioden 2a, 2b, 2c, von denen die erste Laserdiode 2a eine duochromatische Laserdiode ist und die anderen beiden Laserdioden 2b, 2c monochromatische Laserdioden sind. Die erste Laserdiode 2a kann beispielsweise in einem TO-Package ("transistor outline") gehäust sein. Die erste Laserdiode 2a kann beispielsweise rotes sichtbares Laserlicht und infrarotes Laserlicht erzeugen, zum Beispiel mit den Wellenlängen 650 nm oder 635 nm bzw. 780 nm. die zweiten und dritten Laserdioden 2b, 2c können beispielsweise grünes und blaues sichtbares Laserlicht erzeugen, zum Beispiel 532nm bzw. 473 nm. Auf diese Weise kann die Laserdiodenanordnung 2 sichtbares RGB-Laserlicht bereitstellen, und zusätzlich infrarotes Laserlicht zur Implementierung von Interaktivitätsfunktionalität.

Die Optikanordnung 3 umfasst jeweils Kollimatoroptiken 5a, 5b, 5c, die jeweils einer der Laserdioden 2a, 2b bzw. 2c zugeordnet sind, und deren Strahlenbündel 3a, 3b, 3c kollimieren können. Die Kollimatoroptiken 5a, 5b, 5c können beispielsweise jeweils zwei Linsen 6a, 7a bzw. 6b, 7b bzw. 6c, 7c aufweisen und jeweils auf das sichtbare Laserlicht eingestellt sein, so dass die bildgebenden Laserstrahlen, d.h. die sichtbaren Laserstrahlen optimal kollimiert sind. Durch die Kollimierung des ersten Strahlenbündels 3a auf das Laserlicht der sichtbaren Wellenlänge wird das infrarote Laserlicht der duochromatischen Laserdiode 2a aufgrund der chromatischen Aberration nicht optimal kollimiert. Dadurch wird sich die Spotgröße des infraroten Laserlicht gegenüber dem sichtbaren Laserlicht leicht vergrößern. Beispielsweise kann eine typische Spotgröße des sichtbaren Laserlichts etwa 0,5 bis 1,5 mm betragen, während die typische Spotgröße des infraroten Laserlichts etwa 2,5 bis 3,5 mm beträgt. Zusätzlich wird das infrarote Laserlicht gegenüber dem sichtbaren Laserlicht leicht entlang der optischen Achse versetzt. Dies kann jedoch in Kauf genommen werden, da für die Erfassung von interaktiven Objektpositionen oder Objektbewegungen wird üblicherweise eine erheblich geringere Auflösung benötigt als für die Bildgebung mit dem sichtbaren Licht.

Die kollimierten Strahlenbündel 8a können beispielsweise über Zusammenführeinrichtungen 4a, 4b jeweils zu einem Ausgangsstrahlenbündel 8b bzw. 8c des Lasermoduls 1 zusammengeführt werden. Die Zusammenführeinrichtungen 4a, 4b können beispielsweise dichroitische Spiegel sein. Die dichroitischen Spiegel 4a, 4b können dabei insbesondere gegenüber infrarotem Licht durchlässig sein.

Fig. 2 zeigt eine schematische Darstellung eines Verfahrens 20 zum Erzeugen von Bildern mit einem Bildprojektionssystem, insbesondere mit einem Bildprojektionssystem 100 wie in Fig. 1 dargestellt. Das Verfahren 20 umfasst als ersten Schritt 21 ein Erzeugen eines ersten Strahlenbündels 3a mit einem Laserstrahl einer ersten Wellenlänge und einem Laserstrahl einer zweiten Wellenlänge mithilfe einer duochromatischen Laserdiode 2a. Die duochromatische Laserdiode 2a kann beispielsweise rotes Licht im sichtbaren Bereich und infrarotes Licht erzeugen, zum Beispiel der Wellenlängen 650 nm oder 635 nm bzw. 780 nm. In einem zweiten Schritt 22 erfolgt ein Kollimieren des ersten Strahlenbündels 3a mithilfe einer ersten Kollimatoroptik 5a, wobei die erste Kollimatoroptik 5a auf den Laserstrahl der ersten Wellenlänge eingestellt ist. In einem dritten Schritt 23 erfolgt ein Erzeugen mindestens eines zweiten Strahlenbündels 3b mit einem Laserstrahl einer dritten Wellenlänge mithilfe einer monochromatischen Laserdiode 2b. Die monochromatischen Laserdiode 2b kann beispielsweise grünes sichtbares Licht oder blaues sichtbares Licht erzeugen. In einem vierten Schritt erfolgt ein Kollimieren des zweiten Strahlenbündels 3b mithilfe einer zweiten Kollimatoroptik 5b, wobei die zweite Kollimatoroptik 5b auf den Laserstrahl der dritten Wellenlänge eingestellt ist.

Schließlich erfolgt in einem Schritt 25 ein Zusammenführen des ersten und zweiten Strahlenbündels 3a, 3b zu einem Ausgangsstrahlenbündel 8b bzw. 8c, welches in einem Schritt 26 mithilfe eines Mikrospiegelsystems 9 zum Erzeugen von Bildern auf einer Projektionsfläche 11 projiziert werden kann. Das Mikrospiegelsystem 9 kann dabei beispielsweise in einem Rasterscanverfahren angesteuert werden, um einen matrixartigen Bildaufbau mit dem Ausgangsstrahlenbündel 8b bzw. 8c zu erreichen.

Optional kann vorgesehen sein, ein drittes Strahlenbündel 3c einer weiteren monochromatischen Laserdiode 2c mit dem Ausgangsstrahlenbündel 8b zu einem Ausgangsstrahlenbündel 8c zusammenzuführen, beispielsweise grünes sichtbares Licht oder blaues sichtbares Licht. Dies ermöglicht das Erzeugen eines Ausgangsstrahlenbündels 8c, welches dreifarbiges sichtbares Laserlicht (RGB-Laserlicht) und einen zusätzlichen Laserstrahl einer zusätzlichen Frequenz (beispielsweise Infrarotlaserlicht) beinhaltet.

Optional kann in einem Schritt 27 ein Erfassen von an in der Nähe der Projektionsfläche 11 befindlichen Objekten reflektierten Strahlen des Laserstrahls der zweiten Wellenlänge erfolgen, so dass in einem optionalen Schritt 28 ein Ermitteln von Objektpositionen oder Objektbewegungen der Objekte auf der Basis der erfassten reflektierten Strahlen möglich ist.

## Patentansprüche

1. Lasermodul (1) für ein Bildprojektionssystem, mit:
einer duochromatischen Laserdiode (2a), welche dazu ausgelegt ist, ein erstes Strahlenbündel (3a) mit Laserlicht einer ersten Wellenlänge und Laserlicht einer zweiten Wellenlänge zu erzeugen;
einer ersten Kollimatoroptik (5a), welche dazu ausgelegt ist, das erste Strahlenbündel (3a) zu kollimieren;
mindestens einer ersten monochromatischen Laserdiode, welche dazu ausgelegt ist, ein zweites Strahlenbündel (3b) mit Laserlicht einer dritten Wellenlänge zu erzeugen; einer zweiten Kollimatoroptik (5b), welche dazu ausgelegt ist, das zweite Strahlenbündel (3b) zu kollimieren;
einer ersten optischen Zusammenführeinrichtung (4a), welche dazu ausgelegt ist, das erste und zweite kollimierte Strahlenbündel (3a, 3b) zu einem Ausgangsstrahlenbündel (8b, 8c) des Lasermoduls (1) zusammenzuführen;
einer zweiten monochromatischen Laserdiode (2c), welche dazu ausgelegt ist, ein drittes Strahlenbündel (3c) mit Laserlicht einer vierten Wellenlänge zu erzeugen;
einer dritten Kollimatoroptik (5c), welche dazu ausgelegt ist, das dritte Strahlenbündel (3c) zu kollimieren;
einer zweiten optischen Zusammenführeinrichtung (4b), welche dazu ausgelegt ist, das erste, zweite und dritte kollimierte Strahlenbündel (3a, 3b, 3c) zu dem Ausgangsstrahlenbündel (8c) des Lasermoduls (1) zusammenzuführen; und
wobei die erste, dritte und vierte Wellenlänge im sichtbaren optischen Bereich liegen, und die zweite Wellenlänge im Infrarotbereich liegt.

2. Lasermodul (1) nach Anspruch 1, wobei die erste, zweite und dritte Kollimatoroptik (5a, 5b, 5c) jeweils zwei Linsen (6a, 7a; 6b, 7b; 6c, 7c) umfassen.

3. Lasermodul (1) nach einem der Ansprüche 1 oder 2, wobei die duochromatische Laserdiode (2a) in einem TO-Package gehäust ist.

4. Lasermodul (1) nach einem der Ansprüche 1 bis 3, wobei die erste und zweite optische Zusammenführeinrichtung (4a, 4b) dichroitische Spiegel umfassen.

5. Lasermodul (1) nach einem der Ansprüche 1 bis 4, wobei die erste Kollimatoroptik (5a) auf ein Kollimieren des Laserlichts der ersten Wellenlänge eingestellt ist.

6. Bildprojektionssystem (100), mit:
einem Lasermodul (1) nach einem der Ansprüche 1 bis 5; und
einem Mikrospiegelsystem (9), welches steuerbare Mikrospiegel (9a) aufweist, die dazu ausgelegt sind, ein von dem Lasermodul (1) erzeugtes Ausgangsstrahlbündel (8b, 8c) zum Erzeugen von Bildern (10) auf eine Projektionsfläche (11) zu projizieren.

7. Verfahren (20) zum Erzeugen von Bildern mit einem Bildprojektionssystem (100), mit den Schritten:
Erzeugen (21) eines ersten Strahlenbündels (3a) mit einem Laserstrahl einer ersten Wellenlänge und einem Laserstrahl einer zweiten Wellenlänge mithilfe einer duochromatischen Laserdiode (2a);
Kollimieren (22) des ersten Strahlenbündels (3a) mithilfe einer ersten Kollimatoroptik (5a), wobei die erste Kollimatoroptik (5a) auf den Laserstrahl der ersten Wellenlänge eingestellt ist;
Erzeugen (23) mindestens eines zweiten Strahlenbündels (3b) mit einem Laserstrahl einer dritten Wellenlänge mithilfe einer monochromatischen Laserdiode (2b);
Kollimieren (24) des zweiten Strahlenbündels (3b) mithilfe einer zweiten Kollimatoroptik (5b), wobei die zweite Kollimatoroptik (5b) auf den Laserstrahl der dritten Wellenlänge eingestellt ist;
Zusammenführen (25) des ersten und zweiten kollimierten Strahlenbündels (3a, 3b) zu einem Ausgangsstrahlenbündel (8b, 8c);
Erzeugen eines dritten Strahlenbündels (3c) mit einem Laserstrahl einer vierten Wellenlänge mithilfe einer monochromatischen Laserdiode (2c);
Kollimieren des dritten Strahlenbündels (3c) mithilfe einer dritten Kollimatoroptik (5c), wobei die dritte Kollimatoroptik (5c) auf den Laserstrahl der vierten Wellenlänge eingestellt ist;
Zusammenführen des ersten, zweiten und dritten kollimierten Strahlenbündels (3a, 3b, 3c) zu dem Ausgangsstrahlenbündel (8c); und Projizieren (26) des Ausgangsstrahlenbündels (8b, 8c) mithilfe eines Mikrospiegelsystems (9) zum Erzeugen von Bildern auf einer Projektionsfläche (11);
wobei die erste, dritte und vierte Wellenlänge im sichtbaren optischen Bereich liegen, und die zweite Wellenlänge im Infrarotbereich liegt.

8. Verfahren (20) nach Anspruch 7, weiterhin mit den Schritten:
Erfassen (27) von an in der Nähe der Projektionsfläche (11) befindlichen Objekten reflektierten Strahlen des Laserstrahls der zweiten Wellenlänge; und
Ermitteln (28) von Objektpositionen oder Objektbewegungen der Objekte auf der Basis der erfassten reflektierten Strahlen.

## Claims

1. Laser module (1) for an image projection system, having:
a dichromatic laser diode (2a), which is designed to generate a first beam (3a) with laser light at a first wavelength and laser light at a second wavelength;
a first collimating optical unit (5a), which is designed to collimate the first beam (3a);
at least one first monochromatic laser diode, which is designed to generate a second beam (3b) with laser light at a third wavelength;
a second collimating optical unit (5b), which is designed to collimate the second beam (3b);
a first optical combining apparatus (4a), which is designed to combine the first and second collimated beam (3a, 3b) into an output beam (8b, 8c) of the laser module (1);
a second monochromatic laser diode (2c), which is designed to generate a third beam (3c) with laser light at a fourth wavelength;
a third collimating optical unit (5c), which is designed to collimate the third beam (3c);
a second optical combining apparatus (4b), which is designed to combine the first, second and third collimated beam (3a, 3b, 3c) into the output beam (8c) of the laser module (1); and
wherein the first, third and fourth wavelength are in the visible optical range, and the second wavelength is in the infrared range.

2. Laser module (1) according to Claim 1, wherein the first, second and third collimating optical unit (5a, 5b, 5c) comprise two lenses (6a, 7a; 6b, 7b; 6c, 7c) each.

3. Laser module (1) according to either of Claims 1 and 2, wherein the dichromatic laser diode (2a) is housed in a TO package.

4. Laser module (1) according to any of Claims 1 to 3, wherein the first and second optical combining apparatus (4a, 4b) comprise dichroic mirrors.

5. Laser module (1) according to any of Claims 1 to 4, wherein the first collimating optical unit (5a) is set to collimate the laser light at the first wavelength.

6. Image projection system (100), having:
a laser module (1) according to any of Claims 1 to 5; and
a micromirror system (9), which has controllable micromirrors (9a), which are designed to project an output beam (8b, 8c) generated by the laser module (1) onto a projection surface (11) for generating images (10).

7. Method (20) for generating images with an image projection system (100), having the steps of:
generating (21) a first beam (3a) with a laser beam at a first wavelength and a laser beam at a second wavelength with the aid of a dichromatic laser diode (2a) ;
collimating (22) the first beam (3a) with the aid of a first collimating optical unit (5a), wherein the first collimating optical unit (5a) is set for the laser beam at the first wavelength;
generating (23) at least one second beam (3b) with a laser beam at a third wavelength with the aid of a monochromatic laser diode (2b);
collimating (24) the second beam (3b) with the aid of a second collimating optical unit (5b), wherein the second collimating optical unit (5b) is set for the laser beam at the third wavelength;
combining (25) the first and second collimated beam (3a, 3b) into an output beam (8b, 8c);
generating a third beam (3c) with a laser beam at a fourth wavelength with the aid of a monochromatic laser diode (2c);
collimating the third beam (3c) with the aid of a third collimating optical unit (5c), wherein the third collimating optical unit (5c) is set for the laser beam at the fourth wavelength;
combining the first, second and third collimated beam (3a, 3b, 3c) into the output beam (8c); and
projecting (26) the output beam (8b, 8c) with the aid of a micromirror system (9) for generating images on a projection surface (11);
wherein the first, third and fourth wavelength are in the visible optical range, and the second wavelength is in the infrared range.

8. Method (20) according to Claim 7, furthermore having the steps of:
capturing (27) rays of the laser beam at the second wavelength reflected at objects near the projection surface (11); and
ascertaining (28) object positions or object movements of the objects on the basis of the captured reflected rays.

## Revendications

1. Module laser (1) pour un système de projection d'images, comprenant :
une diode laser duochromatique (2a), qui est conçue pour générer un premier faisceau de rayons (3a) avec de la lumière laser d'une première longueur d'onde et de la lumière laser d'une deuxième longueur d'onde ;
une première optique de collimation (5a), qui est conçue pour collimater le premier faisceau de rayons (3a) ;
au moins une première diode laser monochromatique, qui est conçue pour générer un deuxième faisceau de rayons (3b) avec de la lumière laser d'une troisième longueur d'onde ;
une deuxième optique de collimation (5b), qui est conçue pour collimater le deuxième faisceau de rayons (3b) ;
un premier dispositif de regroupement optique (4a), qui est conçu pour regrouper le premier et le deuxième faisceau de rayons (3a, 3b) collimatés en un faisceau de rayons de sortie (8b, 8c) du module laser (1) ;
une deuxième diode laser monochromatique (2c), qui est conçue pour générer un troisième faisceau de rayons (3c) avec de la lumière laser d'une quatrième longueur d'onde ; une troisième optique de collimation (5c), qui est conçue pour collimater le troisième faisceau de rayons (3c) ;
un deuxième dispositif de regroupement optique (4b), qui est conçu pour regrouper le premier, le deuxième et le troisième faisceau de rayons (3a, 3b, 3c) collimatés en le faisceau de rayons de sortie (8c) du module laser (1) ; et
la première, la troisième et la quatrième longueur d'onde se trouvant dans la plage optique visible et la deuxième longueur d'onde se trouvant dans la plage des infrarouges.

2. Module laser (1) selon la revendication 1, la première, la deuxième et la troisième optique de collimation (5a, 5b, 5c) comportant respectivement deux lentilles (6a, 7a ; 6b, 7b ; 6c, 7c).

3. Module laser (1) selon l'une des revendications 1 ou 2, la diode laser duochromatique (2a) étant logée dans un boîtier TO.

4. Module laser (1) selon l'une des revendications 1 à 3, le premier et le deuxième dispositif de regroupement optique (4a, 4b) comportant des miroirs dichroïques.

5. Module laser (1) selon l'une des revendications 1 à 4, la première optique de collimation (5a) étant réglée sur une collimation de la lumière laser de la première longueur d'onde.

6. Système de projection d'images (100), comprenant :
un module laser (1) selon l'une des revendications 1 à 5 ; et
un système de micromiroirs (9) qui comporte des micromiroirs (9a) commandables, lesquels sont conçus pour projeter un faisceau de rayons de sortie (8b, 8c) généré par le module laser (1) sur une surface de projection (11) en vue de générer des images (10).

7. Procédé (20) pour générer des images avec un système de projection d'images (100), comprenant les étapes suivantes :
génération (21) d'un premier faisceau de rayons (3a) avec un rayon laser d'une première longueur d'onde et un rayon laser d'une deuxième longueur d'onde à l'aide d'une diode laser duochromatique (2a) ;
collimation (22) du premier faisceau de rayons (3a) à l'aide d'une première optique de collimation (5a), la première optique de collimation (5a) étant réglée sur le rayon laser de la première longueur d'onde ;
génération (23) d'au moins un deuxième faisceau de rayons (3b) avec un rayon laser d'une troisième longueur d'onde à l'aide d'une diode laser monochromatique (2b) ;
collimation (24) du deuxième faisceau de rayons (3b) à l'aide d'une deuxième optique de collimation (5b), la deuxième optique de collimation (5b) étant réglée sur le rayon laser de la troisième longueur d'onde ;
regroupement (25) du premier et du deuxième faisceau de rayons (3a, 3b) collimatés en un faisceau de rayons de sortie (8b, 8c) ;
génération d'un troisième faisceau de rayons (3c) avec un rayon laser d'une quatrième longueur d'onde à l'aide d'une diode laser monochromatique (2c) ;
collimation du troisième faisceau de rayons (3c) à l'aide d'une troisième optique de collimation (5c), la troisième optique de collimation (5c) étant réglée sur le rayon laser de la quatrième longueur d'onde ;
regroupement du premier, du deuxième et du troisième faisceau de rayons (3a, 3b, 3c) collimatés en le faisceau de rayons de sortie (8c) ; et
projection (26) du faisceau de rayons de sortie (8b, 8c) à l'aide d'un système de micromiroirs (9) en vue de générer des images sur une surface de projection (11) ;
la première, la troisième et la quatrième longueur d'onde se trouvant dans la plage optique visible et la deuxième longueur d'onde se trouvant dans la plage des infrarouges.

8. Procédé (20) selon la revendication 7, comprenant en outre les étapes suivantes :
détection (27) de rayons du rayon laser de la deuxième longueur d'onde réfléchis sur des objets qui se trouvent à proximité de la surface de projection (11) ; et
détermination (28) de positions d'objets ou de mouvements d'objets des objets sur la base des rayons réfléchis détectés.
